# EUROPÄISCHE PATENTSCHRIFT

(11) **EP 2 235 829 B1**
(45) Veröffentlichungstag und Bekanntmachung des Hinweises auf die Patenterteilung: **13.07.2011**
(21) Anmeldenummer: 09756281.3
(22) Anmeldetag: 03.11.2009
(51) Int. Cl.: H03K 17/96

(54) **SCHALTUNGSANORDNUNG ZUR KAPAZITÄTSBESTIMMUNG VON MINDESTENS ZWEI KAPAZITIVEN SENSORELEMENTEN**
CIRCUIT ARRANGEMENT FOR DETERMINING THE CAPACITANCE OF AT LEAST TWO CAPACITIVE SENSOR ELEMENTS
CIRCUIT DE DÉTERMINATION DE LA CAPACITÉ D'AU MOINS DEUX ÉLÉMENTS DE DÉTECTION CAPACITIFS

(30) Priorität: 07.11.2008 DE 102008057433
(43) Veröffentlichungstag der Anmeldung: 06.10.2010
(73) Patentinhaber: E.G.O. Elektro-Gerätebau GmbH, 75038 Oberderdingen (DE)
(72) Erfinder: FIX, Thorsten, 75177 Pforzheim (DE)
(74) Vertreter: Patentanwälte Ruff, Wilhelm, Beier, Dauster & Partner
(86) Internationale Anmeldenummer: PCT/EP2009/064499
(87) Internationale Veröffentlichungsnummer: WO 2010/052200

(56) Entgegenhaltungen:
- WO-A1-2006/133082
- DE-A1- 10 303 480
- US-A- 5 012 124

## Beschreibung

Die Erfindung betrifft eine Schaltungsanordnung zur Kapazitätsbestimmung von mindestens zwei kapazitiven Sensorelementen.

In der DE 10 2006 045 737 A1 ist eine Schaltungsanordnung zum Bestimmen einer Kapazität eines kapazitiven Sensorelements beschrieben, die eine zuverlässige Kapazitätsbestimmung unter allen Betriebsbedingungen gewährleistet, kostengünstig herstellbar und unempfindlich gegenüber EMV- und HF-Störungen ist. Die gezeigte Schaltungsanordnung ermöglicht die Kapazitätsbestimmung eines einzelnen Sensorelements.

Eine Schaltung mit meheren kapazitiven Sensorelementen mit jeweils einen Kondensator wird beispielhaft in dem Dokument US 5, 012, 1224 beschrieben.

### Aufgabe und Lösung

Der Erfindung liegt die Aufgabe zugrunde, auf Basis der in der DE 10 2006 045 737 A1 gezeigten Schaltungsanordnung eine Schaltungsanordnung zur Verfügung zu stellen, die eine Kapazitätsbestimmung von mindestens zwei kapazitiven Sensorelementen mit möglichst wenigen Bauelementen ermöglicht.

Die Erfindung löst diese Aufgabe durch eine Schaltungsanordnung mit den Merkmalen des Anspruchs 1. Vorteilhafte sowie bevorzugte Ausgestaltungen der Erfindung sind Gegenstand der weiteren Ansprüche und werden im Folgenden näher erläutert. Der Wortlaut der Ansprüche wird durch ausdrückliche Bezugnahme zum Inhalt der Beschreibung gemacht.

Die erfindungsgemäße Schaltungsanordnung zur Kapazitätsbestimmung von mindestens zwei kapazitiven Sensorelementen, deren jeweilige Kapazität sich in Abhängigkeit von ihrem jeweiligen Betätigungszustand ändert, umfasst eine Ladespannungsquelle, die zum Erzeugen einer Ladespannung ausgebildet ist, wobei die Ladespannung insbesondere keine Gleichspannung ist, einen Integrationskondensator, wobei ein erster Anschluss des Integrationskondensators mit der Ladespannungsquelle gekoppelt ist, eine Anzahl von Sensorschaltungen, wobei die Anzahl der Sensorschaltungen der Anzahl der Sensorelemente entspricht und einem jeweiligen Sensorelement eine Sensorschaltung zugeordnet ist, wobei eine jeweilige Sensorschaltung ein steuerbares Schaltmittel, eine Ladediode und eine Umladediode umfasst, wobei das steuerbare Schaltmittel und die Ladediode in Serie zwischen die Ladespannungsquelle und einen Anschluss des kapazitiven Sensorelements eingeschleift sind und die Umladediode zwischen den Anschluss des kapazitiven Sensorelements und einen zweiten Anschluss des Integrationskondensators eingeschleift ist, eine Steuereinheit, die dazu ausgebildet ist, die jeweiligen steuerbaren Schaltmittel der Sensorschaltungen derart anzusteuern, dass nur ein einziges der Schaltmittel geschlossen ist und die verbleibenden Schaltmittel geöffnet sind, und eine Auswerteschaltung, die mit dem zweiten Anschluss des Integrationskondensators verbunden ist und die derart ausgebildet ist, dass sie eine an dem zweiten Anschluss des Integrationskondensators anstehende Spannung zum Bestimmen der Kapazität desjenigen Sensorelements auswertet, dessen Schaltmittel geschlossen ist. Die erfindungsgemäße Schaltungsanordnung ermöglicht eine Kapazitätsbestimmung von mehreren kapazitiven Sensorelementen mit einer minimierten Anzahl der dafür benötigten Bauelemente, da der Integrationskondensator und die Auswerteschaltung nur einmal vorzusehen sind.

In einer Weiterbildung umfasst die Auswerteschaltung einen Tiefpass, der aus der an dem zweiten Anschluss des Integrationskondensators anstehenden Spannung einen Gleichspannungsanteil extrahiert, wobei die Auswerteschaltung derart ausgebildet ist, dass sie den Gleichspannungsanteil zum Bestimmen der Kapazität auswertet. Da die Ladespannung keine Gleichspannung ist, ist der an dem zweiten Anschluss des Integrationskondensators anstehenden Spannung ein Wechselspannungsanteil überlagert, der durch den Tiefpass im Wesentlichen entfernt wird. Der Gleichspannungsanteil ist eine Funktion der zu bestimmenden Kapazität.

In einer Weiterbildung umfasst der Tiefpass einen Widerstand und einen Kondensator, die seriell zwischen den zweiten Anschluss des Integrationskondensators und ein Bezugspotential, insbesondere Masse, eingeschleift sind, wobei zum Bestimmen der Kapazität eine an einem Verbindungsknoten des Widerstands und des Kondensators anstehende Spannung ausgewertet wird.

In einer Weiterbildung ist die Ladespannungsquelle eine Rechteckspannungsquelle. Hierbei findet in derjenigen Sensorschaltung, deren Schaltmittel geschlossen ist, in den "High"-Phasen der rechteckförmigen Ladespannung ein Ladevorgang des kapazitiven Sensorelements statt und in den "Low"-Phasen der Ladespannung findet ein Ladungstransfer von dem kapazitiven Sensorelement auf den Integrationskondensator statt. Alternativ kann beispielsweise auch eine sinusförmige Spannung oder eine Dreickspannung verwendet werden.

In einer Weiterbildung ist dem Integrationskondensator ein Widerstand parallel geschaltet. Der Widerstand kann zur Bedämpfung und/oder zu einer definierten, kontinuierlichen Entladung des Integrationskondensators dienen.

In einer Weiterbildung ist zwischen die Ladespannungsquelle und die Ladediode ein Widerstand eingeschleift. Der Widerstand kann beispielsweise zur Begrenzung des aus der Ladespannungsquelle fließenden Stroms verwendet werden.

In einer Weiterbildung sind die Ladespannungsquelle, die Steuereinheit und die Auswerteschaltung in einen Mikroprozessor integriert. Dies ermöglicht eine schaltungstechnische Realisierung mit wenigen Bauelementen.

In einer Weiterbildung ist die Auswerteschaltung derart ausgebildet, dass sie eine Kapazitätsänderung zur Bestimmung des Betätigungszustands auswertet. Da sich bei einer Betätigung des kapazitiven Sensorelements dessen Kapazität verändert, kann aus der ermittelten Kapazität bzw. aus der ermittelten Kapazitätsänderung auf einen Betätigungszustand geschlossen werden.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränkt die unter diesen gemachten Aussagen nicht in ihrer Allgemeingültigkeit.

### Kurzbeschreibung der Zeichnungen

Vorteilhafte Ausführungsformen der Erfindung sind in den Zeichnungen schematisch dargestellt und werden nachfolgend beschrieben. Hierbei zeigt:
- Fig. 1: ein Schaltbild einer ersten Ausführungsform einer erfin- dungsgemäßen Schaltungsanordnung zur Kapazitätsbe- stimmung von mindestens zwei kapazitiven Sensorelemen- ten und
- Fig. 2: ein Schaltbild einer zweiten Ausführungsform einer erfin- dungsgemäßen Schaltungsanordnung zur Kapazitätsbe- stimmung von mindestens zwei kapazitiven Sensorelemen- ten.

### Detaillierte Beschreibung der Zeichnungen

Wenn ein Element als mit einem anderen Element "verbunden" oder "gekoppelt" bezeichnet wird, können die Elemente direkt, d. h. ohne zwischengeschaltete Elemente, miteinander verbunden bzw. gekoppelt sein oder es können zwischengeschaltete Elemente vorhanden sein. Wenn ein Element jedoch als mit einem anderen Element "direkt verbunden" oder "direkt gekoppelt" bezeichnet wird, sind keine zwischengeschalteten Elemente vorhanden.

Die nachfolgend beschrieben Ausführungsformen basieren auf der in der DE 10 2006 045 737 A1 beschriebenen Schaltungsanordnung. Um weitschweifige Wiederholungen möglichst zu vermeiden, sei auch auf die dortige Offenbarung, insbesondere des Funktionsgrundprinzips, verwiesen.

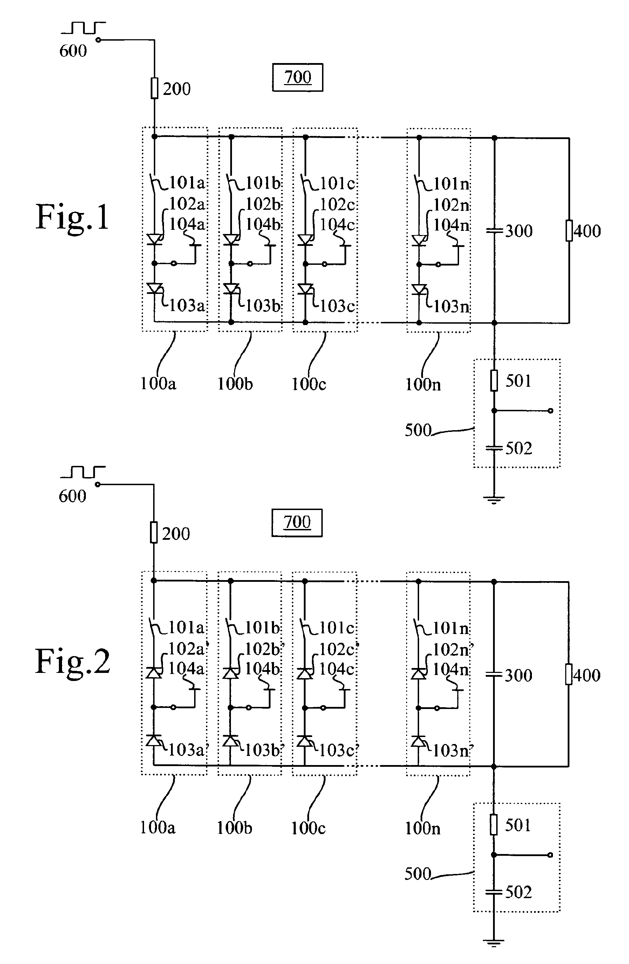

Fig. 1 zeigt ein Schaltbild einer ersten Ausführungsform einer erfindungsgemäßen Schaltungsanordnung zur Kapazitätsbestimmung von n kapazitiven Sensorelementen 104a bis 104n, wobei n eine natürliche Zahl größer als eins ist.

Die kapazitiven Sensorelemente 104a bis 104n bilden jeweils einen Kondensator, wobei eine erste Kondensatorplatte beispielsweise durch eine nicht gezeigte, leitfähige, insbesondere ebene und flächige Schicht gebildet wird, die beispielsweise unter einer nicht gezeigten Glaskeramikplatte eines Kochfeldes angeordnet sein kann. Eine zweite Kondensator-"Platte" wird beispielsweise durch einen Finger eines Benutzers bzw. durch den Benutzer selbst gebildet. Die Glaskeramikplatte bildet ein Dielektrikum zwischen den beiden Kondensatorplatten.

Die kapazitiven Sensorelemente 104a bis 104n können durch ihr jeweiliges elektrisches Ersatzschaltbild in Form eines Kondensators dargestellt werden. Die Kapazität des Kondensators ändert sich in Abhängigkeit vom Betätigungszustand, d. h. in Abhängigkeit davon, in welchem Abstand sich beispielsweise ein Finger von der leitfähigen Schicht befindet. Die Kapazität des Kondensators nimmt bei kleiner werdendem Abstand zu. Aus der Kapazität bzw. der Kapazitätsänderung des Kondensators kann folglich ermittelt werden, ob eine Betätigung des kapazitiven Näherungsschalters bzw. des kapazitiven Sensorelements 104 erfolgt.

Die gezeigte Schaltungsanordnung umfasst ferner eine Ladespannungsquelle 600, die zum Erzeugen einer rechteckförmigen Ladespannung ausgebildet ist. Die Ladespannung kann beispielsweise mit ca. 200kHz zwischen 0V und 5V umgeschaltet werden. Ein Tastverhältnis kann beispielsweise 50% betragen.

Ein Integrationskondensator 300 ist mit einem ersten Anschluss mit der Ladespannungsquelle 600 gekoppelt. Ein optionaler Widerstand 400 ist dem Integrationskondensator 300 parallel geschaltet. Der Widerstand 400 dient zur Bedämpfung und zur Störungsunterdrückung.

Den kapazitiven Sensorelementen 104a bis 104n sind jeweils Sensorschaltungen 100a bis 100n zugeordnet, wobei eine jeweilige Sensorschaltung 100a bis 100n ein steuerbares Schaltmittel 101, beispielsweise einen Transistor, eine Ladediode 102 und eine Umladediode 103 umfasst. Das steuerbare Schaltmittel 101 und die Ladediode 102 sind in Serie zwischen die Ladespannungsquelle 600 und einen Anschluss des kapazitiven Sensorelements 104 eingeschleift. Die Umladediode 103 ist zwischen den Anschluss des kapazitiven Sensorelements 104 und einen zweiten Anschluss des Integrationskondensators 300 eingeschleift. Bei der gezeigten Ausführungsform sind die Ladediode 102 und die Umladediode 103 in Durchflussrichtung zwischen die Ladespannungsquelle 600 und den zweiten Anschluss des Integrationskondensators 300 eingeschleift.

Ein optionaler Widerstand 200 ist zwischen die Ladespannungsquelle 600 und die Sensorschaltungen 100a bis 100n eingeschleift.

Eine Steuereinheit 700 ist dazu ausgebildet, die jeweiligen steuerbaren Schaltmittel 101a bis 101 n der Sensorschaltungen 100a bis 100n derart anzusteuern, dass nur ein einziges der Schaltmittel geschlossen ist und die verbleibenden Schaltmittel geöffnet sind. Um alle kapazitiven Sensorelemente 104a bis 104n nacheinander auszuwerten, kann die Steuereinheit 700 beispielsweise sequentiell jeweils eines der Schaltmittel 101a bis 101 n von links nach rechts schließen, wodurch eine Auswahl eines spezifischen Sensorelements erfolgt. Diejenigen Sensorelemente, deren zugehörige Sensorschaltung ein geöffnetes Schaltmittel aufweist, sind aufgrund des geöffneten Schaltmittels und der sperrenden Umladediode von der Auswerteschaltung 500 entkoppelt, d. h. haben auf die Auswertung des momentan ausgewählten bzw. aktiven Sensorelements keinen Einfluss.

Eine Auswerteschaltung 500 ist mit dem zweiten Anschluss des Integrationskondensators 300 verbunden und ist derart ausgebildet, dass sie eine an dem zweiten Anschluss des Integrationskondensators 300 anstehende Spannung zum Bestimmen der Kapazität desjenigen Sensorelements auswertet, dessen Schaltmittel momentan geschlossen ist, d. h. das ausgewählt ist. Die Auswerteschaltung 500 umfasst einen RC-Tiefpass in Form des Widerstands 501 und des Kondensators 502, wobei der Widerstand 501 und der Kondensator 502 seriell zwischen den zweiten Anschluss des Integrationskondensators 300, an dem die auszuwertende Spannung ansteht, und ein Bezugspotential, beispielsweise Masse oder Erde, eingeschleift sind.

Ein Verbindungsknoten zwischen dem Widerstand 501 und dem Kondensator 502 kann beispielsweise mit einem analogen Eingangsanschluss eines nicht gezeigten Mikroprozessors verbunden sein, wobei der Mikroprozessor die dort anstehende Spannung zur Bestimmung oder Ermittlung der Kapazität und somit des Betätigungszustands des ausgewählten kapazitiven Sensorelements 104 auswertet. Der RC-Tiefpass 501, 502 dient zur Unterdrückung des Wechselspannungsanteils der am zweiten Anschluss des Integrationskondensators 300 anstehenden Spannung.

Die Ladespannungsquelle 600, die Steuereinheit 700 und die Auswerteschaltung 500 oder Teile der Auswerteschaltung 500 können in einen nicht gezeigten Mikroprozessor integriert sein.

Bei der in Fig. 2 gezeigten, alternativen Ausführungsform sind lediglich die Ladediode 102' und die Umladediode 103' anstatt in Durchlassrichtung in Sperrrichtung zwischen die Ladespannungsquelle 600 und den zweiten Anschluss des Integrationskondensators 300 eingeschleift.

Die gezeigten Ausführungsformen ermöglichen eine Bestimmung der Kapazität mehrerer kapazitiver Sensorelemente auf Basis des switched-Capacitor-Prinzips, wobei die Anzahl der pro Sensorelement notwendigen Bauelemente minimiert ist.

## Patentansprüche

1. Schaltungsanordnung zur Kapazitätsbestimmung von mindestens zwei kapazitiven Sensorelementen (104a∼104n), deren jeweilige Kapazität sich in Abhängigkeit von ihrem jeweiligen Betätigungszustand ändert, mit
- einer Ladespannungsquelle (600), die zum Erzeugen einer Ladespannung ausgebildet ist,
- einem Integrationskondensator (300), wobei ein erster Anschluss des Integrationskondensators mit der Ladespannungsquelle (600) gekoppelt ist,
- einer Anzahl von Sensorschaltungen (100a∼100n), wobei die Anzahl der Sensorschaltungen (100a∼100n) der Anzahl der Sensorelemente (104a∼104n) entspricht und einem jeweiligen Sensorelement (104a∼104n) eine Sensorschaltung (100a∼100n) zugeordnet ist, wobei eine jeweilige Sensorschaltung (100a∼100n) umfasst:
- ein steuerbares Schaltmittel (101),
- eine Ladediode (102) und
- eine Umladediode (103),
- wobei das steuerbare Schaltmittel (101) und die Ladediode (102) in Serie zwischen die Ladespannungsquelle (600) und einen Anschluss des kapazitiven Sensorelements (104) eingeschleift sind und
- die Umladediode (103) zwischen den Anschluss des kapazitiven Sensorelements (104) und einen zweiten Anschluss des Integrationskondensators (300) eingeschleift ist,
- einer Steuereinheit (700), die dazu ausgebildet ist, die jeweiligen steuerbaren Schaltmittel (101a∼101n) der Sensorschaltungen (100a∼100n) derart anzusteuern, dass nur ein einziges der Schaltmittel geschlossen ist und die verbleibenden Schaltmittel geöffnet sind, und
- einer Auswerteschaltung (500), die mit dem zweiten Anschluss des Integrationskondensators (300) verbunden ist und die derart ausgebildet ist, dass sie eine an dem zweiten Anschluss des integrationskondensators (300) anstehende Spannung zum Bestimmen der Kapazität desjenigen Sensorelements auswertet, dessen Schaltmittel geschlossen ist.

2. Schaltungsanordnung nach Anspruch 1, **dadurch gekennzeichnet, dass** die Auswerteschaltung einen Tiefpass umfasst, der aus der an dem zweiten Anschluss des Integrationskondensators anstehenden Spannung einen Gleichspannungsanteil extrahiert, wobei die Auswerteschaltung derart ausgebildet ist, dass sie den Gleichspannungsanteil zum Bestimmen der Kapazität auswertet.

3. Schaltungsanordnung nach Anspruch 2, **dadurch gekennzeichnet, dass** der Tiefpass einen Widerstand (501) und einen Kondensator (502) umfasst, die seriell zwischen den zweiten Anschluss des Integrationskondensators und ein Bezugspotential eingeschleift sind, wobei zum Bestimmen der Kapazität eine an einem Verbindungsknoten des Widerstands und des Kondensators anstehende Spannung ausgewertet wird.

4. Schaltungsanordnung nach einem der vorhergehenden Ansprüche, **dadurch gekennzeichnet, dass** die Ladespannungsquelle eine Rechteckspannungsquelle ist.

5. Schaltungsanordnung nach einem der vorhergehenden Ansprüche, **dadurch gekennzeichnet, dass** dem integrationskondensator ein Widerstand (400) parallel geschaltet ist.

6. Schaltungsanordnung nach einem der vorhergehenden Ansprüche, **dadurch gekennzeichnet, dass** zwischen die Ladespannungsquelle und die Ladediode ein Widerstand (200) eingeschleift ist.

7. Schaltungsanordnung nach einem der vorhergehenden Ansprüche, **dadurch gekennzeichnet, dass** die Ladespannungsquelle, die Steuereinheit und die Auswerteschaltung in einen Mikroprozessor integriert sind.

8. Schaltungsanordnung nach einem der vorhergehenden Ansprüche, **dadurch gekennzeichnet, dass** die Auswerteschaltung derart ausgebildet ist, dass sie eine Kapazitätsänderung zur Bestimmung des Betätigungszustands auswertet.

## Claims

1. A circuit arrangement for determining the capacitance of at least two capacitive sensor elements (104a through 104n), the respective capacitance thereof varying in response to the respective actuation condition, comprising
- a charging voltage source (600) arranged to generate a charging voltage,
- an integration capacitor (300), wherein a first terminal of the integration capacitor is coupled to the charging voltage source (600),
- a number of sensor circuits (100a through 100n), wherein the number of sensor circuits (100a through 100n) is correspondent to the number of sensor elements (104a through 104n) and each sensor element (104a through 104n) is assigned a respective sensor circuit (100a through 100n), the respective sensor circuit (100a through 100n) comprising:
- a controllable switching means (101),
- a charging diode (102), and
- a recharging diode (103),
- the controllable switching means (101) and the charging diode (102) being connected in series between the charging voltage source (600) and one terminal of the capacitive sensor element (104), and
- the recharging diode (103) being connected between the terminal of the capacitive sensor element (104) and a second terminal of the integration capacitor (300),
- a controller (700) arranged to control the respective controllable switching means (101 a through 101 n) of the sensor circuits (100a through 100n) in such a manner that only one single switching means is closed and the remaining switching means are opened, and
- an evaluation circuit (500) connected to the second terminal of the integration capacitor (300) and arranged to evaluate a voltage applied to the second terminal of the integration capacitor (300) to determine the capacitance of the sensor element having a closed switching means.

2. The circuit arrangement according to claim 1, **characterized in that** the evaluation circuit includes a low pass to extract a direct current voltage proportion from the voltage applied to the second terminal of the integration capacitor, wherein the evaluation circuit is arranged to evaluate the direct current voltage proportion to determine the capacitance.

3. The circuit arrangement according to claim 2, **characterized in that** the low pass includes a resistor (501) and a capacitor (502) connected in series between the second terminal of the integration capacitor and a reference potential, wherein a voltage applied to a connection node of the resistor and the capacitor is evaluated to determine the capacitance.

4. The circuit arrangement according to any of the preceding claims, **characterized in that** the charging voltage source is a square-wave voltage source.

5. The circuit arrangement according to any of the preceding claims, **characterized in that** the integration capacitor and a resistor (400) are connected in parallel.

6. The circuit arrangement according to any of the preceding claims, **characterized in that** a resistor (200) is connected between the charging voltage source and the charging diode.

7. The circuit arrangement according to any of the preceding claims, **characterized in that** the charging voltage source, the controller, and the evaluation circuit are integrated in a microprocessor.

8. The circuit arrangement according to any of the preceding claims, **characterized in that** the evaluation circuit is arranged to evaluate a capacitance variation to determine the actuation condition.

## Revendications

1. Agencement de circuit pour déterminer la capacité d'au moins deux éléments de détection (104a∼104n) capacitifs, dont la capacité respective varie en fonction de son état d'actionnement respectif, comprenant
- une source de tension de charge (600), qui est conçue pour générer une tension de charge,
- un condensateur d'intégration (300), un premier branchement du condensateur d'intégration étant couplé avec la source de tension de charge (600),
- un certain nombre de circuits de détection (100a∼100n), le nombre des circuits de détection (100a∼100n) correspondant au nombre des éléments de détection (104a∼104n) et un circuit de détection (100a∼100n) étant attribué à un élément de détection (104a∼104n) respectif, un circuit de détection (100a∼100n) respectif comprenant :
- un moyen de commutation (101) contrôlable,
- une diode de charge (102), et
- une diode de renversement de charge (103),
- le moyen de commutation (101) contrôlable et la diode de charge (102) étant intégrés en boucle en série entre la source de tension de charge (600) et un branchement de l'élément de détection (104) capacitif, et
- la diode de renversement de charge (103) étant intégrée en boucle entre le branchement de l'élément de détection (104) capacitif et un second branchement du condensateur d'intégration (300),
- une unité de commande (700), qui est conçue pour activer les moyens de commutation (101a∼101n) contrôlables respectifs des circuits de détection (100a∼100n) de telle sorte qu'un seul des moyens de commutation soit fermé et les moyens de commutation restants soient ouverts, et
- un circuit d'analyse (500), qui est relié au second branchement du condensateur d'intégration (300) et qui est conçu de telle sorte qu'il analyse une tension s'appliquant sur le second branchement du condensateur d'intégration (300) pour déterminer la capacité de l'élément de détection, dont le moyen de commutation est fermé.

2. Agencement de circuit selon la revendication 1, **caractérisé en ce que** le circuit d'analyse présente un filtre passe-bas, qui extrait une partie de tension continue de la tension s'appliquant sur le second branchement du condensateur d'intégration, le circuit d'analyse étant conçu de telle sorte qu'il analyse la partie de tension continue pour déterminer la capacité.

3. Agencement de circuit selon la revendication 2, **caractérisé en ce que** le filtre passe-bas comprend une résistance (501) et un condensateur (502), qui sont intégrés en boucle en série entre le second branchement du condensateur d'intégration et un potentiel de référence, une tension s'appliquant sur un noeud de liaison de la résistance et du condensateur étant analysée pour déterminer la capacité.

4. Agencement de circuit selon l'une quelconque des revendications précédentes, **caractérisé en ce que** la source de tension de charge est une source de tension rectangulaire.

5. Agencement de circuit selon l'une quelconque des revendications précédentes, **caractérisé en ce qu'**une résistance (400) est branchée parallèlement au condensateur d'intégration.

6. Agencement de circuit selon l'une quelconque des revendications précédentes, **caractérisé en ce qu'**une résistance (200) est intégrée en boucle entre la source de tension de charge et la diode de charge.

7. Agencement de circuit selon l'une quelconque des revendications précédentes, **caractérisé en ce que** la source de tension de charge, l'unité de commande et le circuit d'analyse sont intégrés dans un microprocesseur.

8. Agencement de circuit selon l'une quelconque des revendications précédentes, **caractérisé en ce que** le circuit d'analyse est conçu de telle sorte qu'il analyse une variation de capacité pour déterminer l'état d'actionnement.
